# EUROPEAN PATENT APPLICATION

(11) **EP 3 681 255 A1**
(43) Date of publication of application: **15.07.2020**
(21) Application number: 19213728.9
(22) Date of filing: 05.12.2019
(51) Int. Cl.: H05K 1/14, H05K 3/46

(54) **POSITIONING FEATURES FOR LOCATING INLAY BOARDS WITHIN PRINTED WIRING BOARDS**

(30) Priority: 08.01.2019 US 201916242610
(71) Applicant: Hamilton Sundstrand Corporation, Charlotte, NC 28217-4578 (US)
(72) Inventor: COONEY, Robert C., Janesville, WI Wisconsin 53546 (US); KUCHARSKI, David M., Delavan, WI Wisconsin 53115 (US)
(74) Representative: Dehns

(57) **Abstract**

A printed wiring board (PWB) assembly includes a PWB main board (102) defining a recess (104) therein. An inlay (106) is seated within the recess with a gap (108) separating between the PWB main board and the inlay. Spacers (110, 112) are included within the gap to maintain gap width between the PWB main board and the inlay.

## Description

### BACKGROUND OF THE INVENTION

### 1. Field of the Invention

The present disclosure relates to printed wiring boards (PWBs), and more particularly to positioning inlays within PWBs.

### 2. Description of Related Art

Proper positioning of inlays within PWBs can be key to whether or not the PWB functions for its intended purpose. Prepreg (material used to laminate various layers in a PWB assembly) is needed between the main board and the inlay. Therefore, a gap is required around the periphery of the inlay. Further complicating the process is the fact that PWB materials typically expand at different rates from the inlay materials during the lamination process due to the associated temperature rise of lamination. Controlling the gap between the inlay and main board is difficult because of these issues.

The conventional techniques have been considered satisfactory for their intended purpose. However, there is an ever present need for improved positioning of inlays in PWBs. This disclosure provides a solution for this need.

### SUMMARY OF THE INVENTION

A printed wiring board (PWB) assembly includes a PWB main board defining a recess therein. An inlay is seated within the recess with a gap separating between the PWB main board and the inlay. Spacers are included within the gap to maintain gap width between the PWB main board and the inlay.

The gap can define a gap width in a lateral direction from the inlay to the PWB main board, wherein the spacers have a width in the lateral direction less than or equal to the gap width and are entirely within the gap widthwise. The gap width and the width of the spacers can be about 0.010 inches (0.254 mm) in length.

The spacers can extend outward from the inlay. The spacers can extend inward from the PWB main board. At least one of the spacers can extend inward from the PWB and at least one of the spacers can extend outward from the inlay. The spacers can be triangular, semi-circular, or rectangular. The spacers can be external pins configured to be removed during or after lamination.

The assembly can include at least one additional PWB board assembled onto the PWB main board, wherein the at least one additional PWB board includes vias therethrough in electrical communication with the inlay for electrical connection to surface mounted electronic components assembled onto the at least one additional PWB board. At least one additional inlay can be seated within the recess. The at least one additional PWB main board can be assembled thereto having a respective recess, wherein each of the PWB main board recesses includes at least one inlay seated therein.

A method of assembling a printed wiring board (PWB) assembly includes seating an inlay into a recess in a PWB main board, wherein spacers maintain gap width between the PWB main board and the inlay. The method includes laminating the assembled PWB main board and inlay into a laminated assembly. The spacers can be external pins and the method can include at least one of: removing the external pins from the gap during lamination, removing the external pins from the gap after lamination, and filling in voids left after removing the external pins.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic exploded perspective view of an exemplary embodiment of a printed wiring board (PWB) assembly constructed in accordance with the present disclosure, showing the inlay seated in the recess of the PWB main board;
Fig. 2 is a schematic plan view of the PWB main board and inlay of Fig. 1, showing the spacers maintaining the gap;
Figs. 3-6 are a schematic plan views of PWB assemblies in accordance with the present disclosure, showing different respective embodiments of the spacers;
Fig. 7 is a schematic exploded view of another exemplary embodiment of a PWB assembly, showing multiple inlays seated in the recess of the PWB main board; and
Fig. 8 is a schematic exploded view of another exemplary embodiment of a PWB assembly, showing multiple PWB main boards, some of which have multiple inlays seated in the recess thereof.

### DETAILED DESCRIPTION OF THE PREFERRED EMBODIMENTS

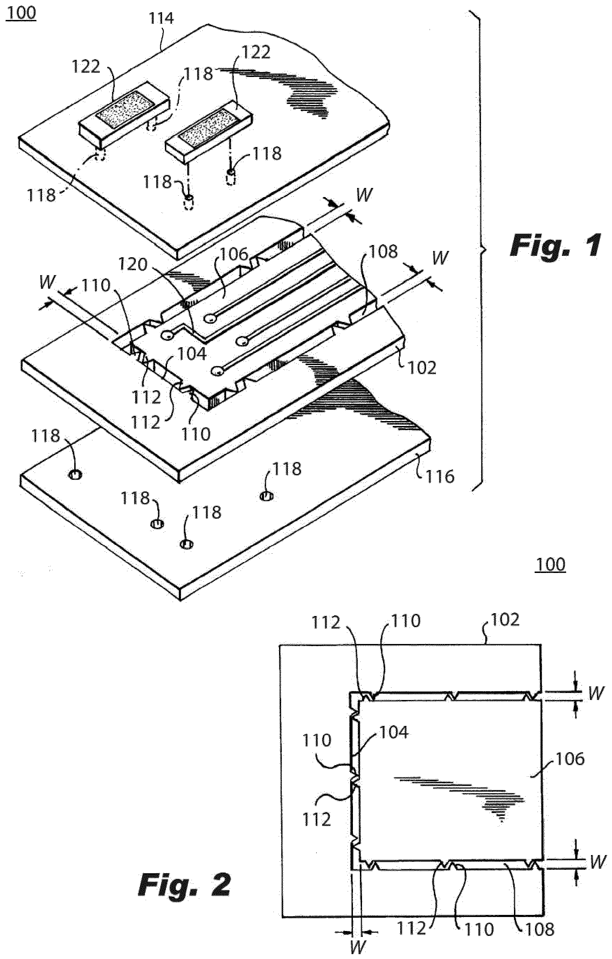

Reference will now be made to the drawings wherein like reference numerals identify similar structural features or aspects of the subject disclosure. For purposes of explanation and illustration, and not limitation, a partial view of an exemplary embodiment of a printed wiring board (PWB) assembly in accordance with the disclosure is shown in Fig. 1 and is designated generally by reference character 100. Other embodiments of PWB assemblies in accordance with the disclosure, or aspects thereof, are provided in Figs. 2-8, as will be described. The systems and methods described herein can be used to maintain the spacing between inlays and PWB main boards and improve manufacturability of PWB assemblies.

The printed wiring board (PWB) assembly 100 includes a PWB main board 102 defining a recess 104 therein. An inlay 106 is seated within the recess 104 with a gap 108 separating between the PWB main board 102 and the inlay 106. Spacers 110, 112 are included within the gap 108 to maintain the gap width W between the PWB main board 102 and the inlay 106.

With reference now to Fig. 2, the gap 108 defines a gap width W in a lateral direction from the inlay 106 to the PWB main board 102 (three different locations are shown for this gap with W in Figs. 1 and 2). The spacers 110, 112 have a width in the same lateral direction as the gap width W that less than or equal to the gap width W. The spacers 110, 112 and are entirely within the gap 108 widthwise. The gap width W and the width of the spacers 110, 112 are about 0.010 inches (0.254 mm) in length.

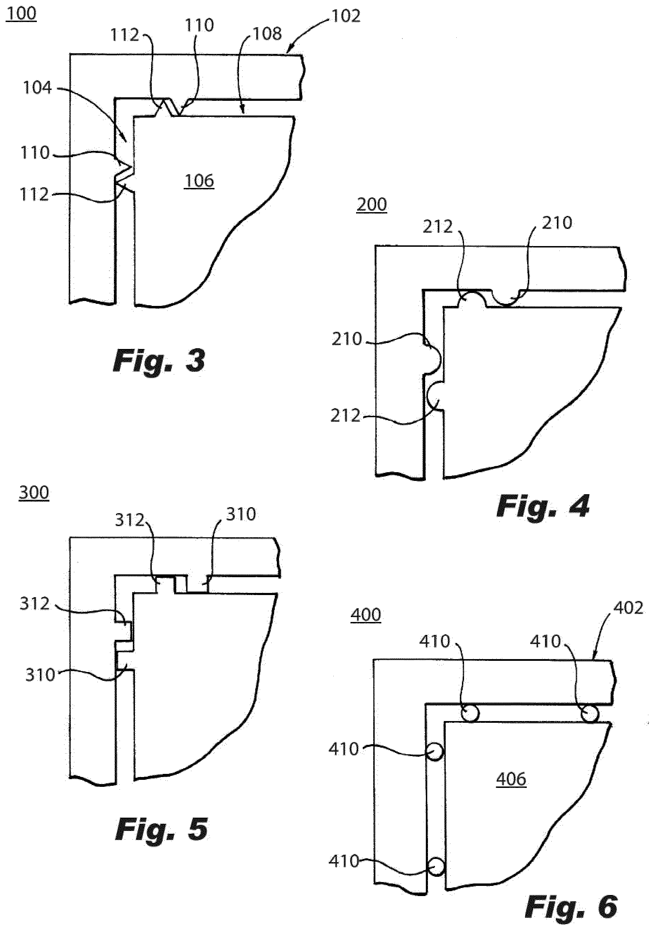

With reference now to Fig. 3, the spacers 110 extend inward from the PWB main board 102, and are integral therewith, e.g., can be machined from the material of the PWB main board 102. The spacers 112 extend outward from the inlay 106 and are integral therewith, e.g., can be machined from material of the inlay 106. Those skilled in the art having had the benefit of this disclosure will readily appreciate that the spacers 110 can be omitted and the spacers 112 will maintain the spacing of the gap 108, and that instead the spacers 112 can be omitted and the spacers 110 will maintain the spacing of the gap 108. In the case that only spacers 110 extending from the PWB main board 102 or only spacers 112 extending outward from the inlay 102, the inlay can optionally be seated in the recess 104 by sliding the inlay laterally, e.g., from right to left as oriented in Fig. 2. If both spacers 110 and spacers 112 are included, the inlay 106 can be seated vertically into the recess 104, e.g., by dropping the inlay 106 down into the plane of the view in Fig. 2.

As shown in Fig. 3, the spacers 110, 112 are triangular. In Fig. 4, another assembly 200 is shown that is similar to assembly 100 described above, but wherein the spacers 210, 212 are semi-circular. In Fig. 5, another assembly 300 is shown that is similar to assembly 100 described above, but wherein the spacers 310, 312 are rectangular. In Fig. 6, another assembly 400 is shown that is similar to the assembly 100 described above, but wherein the spacers 410 not part of the inlay 406 or main board 402 but instead are external pins configured to be removed during or after lamination.

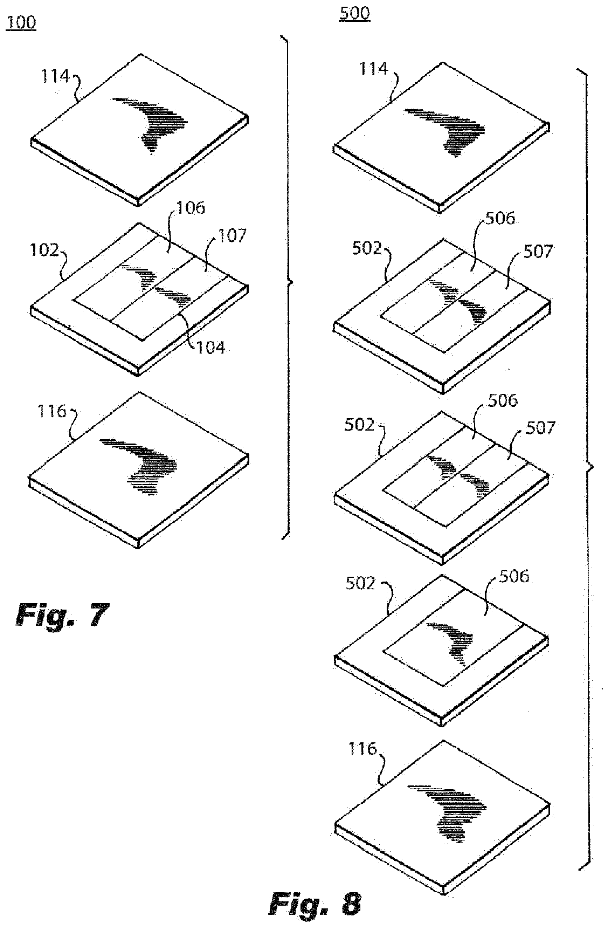

With reference again to Fig. 1, the assembly 100 includes an additional PWB board 114 assembled onto one side of the PWB main board 102, and an additional PWB board 116 assembled onto the opposite side of the PWB main board 102. The additional PWB boards 114, 116 include vias 118 therethrough in electrical communication with wiring feature 120 of the inlay 106 for electrical connection to surface mounted electronic components 122 assembled onto the additional PWB boards 114, 116 (only two of which are shown schematically in Fig. 1). As shown in Fig. 7, it is also contemplated that at least one additional inlay 107 can be seated within the recess 104 with the inlay 106, each inlay 106, 107 can be separated from the other and from the PWB main board 102 with spacers 110 and/or 112 as those described above. It is also contemplated that as shown in Fig. 8, A PWB assembly 500 can include multiple PWB main boards 502, each with one or more inlays 506, 507 spacing for the inlays 506, 507 and their respective PWB main boards 502 is maintained by spacers as described above.

A method of assembling a printed wiring board (PWB) assembly (e.g. PWB assembly 100) includes seating an inlay (e.g. inlay 106) into a recess (e.g. recess 104) in a PWB main board (e.g., PWB main board 102), wherein spacers (e.g. spacers 110, 112) maintain gap width between the PWB main board and the inlay. The method includes laminating the assembled PWB main board and inlay into a laminated assembly. The spacers (e.g. spacers 410) can be external pins and the method can include at least one of: removing the external pins from the gap during lamination, removing the external pins from the gap after lamination, and filling in voids left after removing the external pins.

Systems and methods as disclosed herein provide control of the position of an inlay within a main PWB, reducing the potential tolerance between the different sections of the board. The spacers can be sized to accommodate thermal expansion differentials during the laminating process. The gap between the inlay and a PWB main board can be closely controlled and consistent. An exemplary application is for manufacturing Solid state switch devices (SSSDs).

The methods and systems of the present disclosure, as described above and shown in the drawings, provide for PWB assemblies with superior properties including improved manufacturability due to more reliable maintenance of the spacing between PWB main boards and inlays seated therein. While the apparatus and methods of the subject disclosure have been shown and described with reference to preferred embodiments, those skilled in the art will readily appreciate that changes and/or modifications may be made thereto without departing from the scope of the invention as defined by the claims.

## Claims

1. A printed wiring board, PWB, assembly comprising:
a PWB main board (102) defining a recess (104) therein; and
an inlay (106) seated within the recess with a gap (108) separating between the PWB main board and the inlay, wherein spacers (110, 112) are included within the gap to maintain gap width between the PWB main board and the inlay.

2. The assembly as recited in claim 1, wherein the gap (108) defines a gap width in a lateral direction from the inlay to the PWB main board, wherein the spacers have a width in the lateral direction less than or equal to the gap width and are entirely within the gap widthwise.

3. The assembly as recited in claim 2, wherein the gap width and the width of the spacers are about 0.010 inches (0.254 mm) in length.

4. The assembly as recited in any preceding claim, wherein the spacers (110, 112) extend outward from the inlay.

5. The assembly as recited in any preceding claim, wherein the spacers extend inward from the PWB main board.

6. The assembly as recited in any preceding claim, wherein at least one of the spacers extends inward from the PWB and at least one of the spacers extends outward from the inlay.

7. The assembly as recited in any preceding claim, wherein the spacers are triangular.

8. The assembly as recited in any of claims 1 to 6, wherein the spacers (210, 212) are semi-circular.

9. The assembly as recited in any of claims 1 to 6, wherein the spacers (310, 312) are rectangular.

10. The assembly as recited in any preceding claim, wherein the spacers are external pins configured to be removed during or after lamination.

11. The assembly as recited in any preceding claim, further comprising at least one additional PWB board (114) assembled onto the PWB main board, wherein the at least one additional PWB board includes vias therethrough in electrical communication with the inlay for electrical connection to surface mounted electronic components assembled onto the at least one additional PWB board.

12. The assembly as recited in any preceding claim, wherein the inlay is a first inlay and further comprising at least one additional inlay (107) seated within the recess.

13. The assembly as recited in any preceding claim, wherein the PWB main board is a first PWB main board and further comprising at least one additional PWB main board assembled thereto having a respective recess, wherein each of the PWB main board recesses includes at least one inlay seated therein.

14. A method of assembling a printed wiring board (PWB) assembly comprising:
seating an inlay into a recess in a PWB main board, wherein spacers maintain gap width between the PWB main board and the inlay; and
laminating the assembled PWB main board and inlay into a laminated assembly.

15. The method as recited in claim 14, wherein the spacers are external pins and further comprising at least one of:
removing the external pins from the gap during lamination;
removing the external pins from the gap after lamination; and
filling in voids left after removing the external pins.
